# EUROPEAN PATENT SPECIFICATION

(11) **EP 2 656 471 B1**
(45) Date of publication and mention of the grant of the patent: **25.01.2017**
(21) Application number: 11705886.7
(22) Date of filing: 28.02.2011
(51) Int. Cl.: H02J 7/34, H02J 7/00, H03K 17/16

(54) **ACTIVE CONTROL PROCEDURES FOR THE CONNECTION OF VERY CAPACITIVE LOADS USING SSPCs.**
AKTIVE KONTROLLVERFAHREN FÜR DIE VERBINDUNG VON SEHR KAPAZITIVE LASTEN MITTELS SSPCS
PROCEDURES DE CONTROLE ACTIF POUR LA CONNEXION DE CHARGES TRÈS CAPACITIF UTILISANT SSPCS

(30) Priority: 22.12.2010 ES 201031921
(43) Date of publication of application: 30.10.2013
(73) Proprietor: EADS Construcciones Aeronauticas, S.A., 28022 Madrid (ES); Universidad Carlos III de Madrid, 28911 Leganes Madrid (ES)
(72) Inventor: IZQUIERDO GIL, Daniel, E-28906 Getafe, Madrid (ES); BARRADO BAUTISTA, Andrés, Leganés Madrid (ES); SANZ GARCIA, Clara, Marina, Leganés Madrid (ES); HERNÁNDEZ MORGADO, Roberto, Carlos, Leganés Madrid (ES)
(74) Representative: Elzaburu S.L.P.
(86) International application number: PCT/EP2011/052935
(87) International publication number: WO 2012/084269

(56) References cited:
- US-A- 5 670 863
- US-A1- 2002 033 727
- US-A1- 2008 191 667

## Description

### FIELD OF THE INVENTION

This invention refers to procedures for the active control of the current for the connection of very capacitive loads by using SSPCs in electrical energy distribution systems, particularly in aircraft and other vehicle's electrical. The invention also refers to the SSPCs which permit the implementation of said procedures.

### BACKGROUND OF THE INVENTION

There is a strong trend in the aeronautical industry towards the More Electric Aircraft (MEA) concept as a consequence of substitutions of conventional equipments, which depend on pneumatic, mechanic and hydraulic power, by equipments that depend on electrical power. These new equipments provide an improved operational capacity thanks to an increased reliability, a lesser maintenance, an efficient energy conversion and, therefore, a greater efficiency of the aircraft in general.

To cope with this increase in electrical energy, in the new distribution architectures high voltage levels are used in order to reduce the current levels and, consequently, the cable sections and its weight. On the other hand, more important electric loads can be directly fed with direct current in place of three-phase alternate current, which also means a decrease in the number of cables used to connect the different electric loads.

This considerable growth of the number of electrical loads in these new electric distribution architectures has contributed to an increase of the quantity of the electrical and electronic components, which could conduce to instability of the whole system due to the interactions between the different equipments that compose the system. Also, raising the level of voltage, of the new electrical energy distribution systems, provokes the appearance of new problems regarding the function of some devices, such as conventional protections, and other inconveniences originated by physical effects in the wires with the new levels of voltage: corona effect, arc fault and others.

In the aeronautical industry there is an increasing demand for Electrical Power Systems managed by smart control systems for, particularly, managing the connection and disconnection of the electrical loads depending on the operational mode and available power sources.

As a consequence, solid state power controllers (SSPCs) technology have been introduced inside the electrical management centers. These components have been grouped in Electrical Power Load Management Units (EPLMUs) which offer a number of advantages over electromechanical relays and conventional circuit breakers (CBs).

Other SSPC characteristics are high reliability, low power dissipation and remote control capability by means of complex hardware. Moreover, these devices, based on power semiconductors, provide a fast response and a lower susceptibility to vibrations in comparison to electromagnetic and electromechanic components, such as CBs.

In these systems, the connection of very capacitive loads using SSPCs can cause overcurrents which, on the one hand, can irreversibly damage the SSPCs and, on the other hand, introduce perturbations which can affect the rest of the neighbouring components or the own power source.

It is known document US2002/033727 that discloses that conventionally, in an electrical device having an output transistor for limiting an input current to produce an output current and a bypass capacitor connected to the output side of the output transistor, the waveform of the current that charges the bypass capacitor cannot be adjusted without varying the capacitance of the bypass capacitor. In an electrical device embodying said invention, the waveform of the current that charges the bypass capacitor can be adjusted by varying the limit value of the output current without varying the capacitance of the bypass capacitor.

These perturbations and overcurrents generate serious problems in onboard electrical distribution systems, and this invention is, therefore, oriented towards solving said problems.

### SUMMARY OF THE INVENTION

An object of the present invention is to provide procedures for the connection of very capacitive loads to electric distribution systems using SSPCs which allow a decrease of the perturbations introduced in the system by the connection transients.

Another object of the present invention is to provide procedures for the connection of very capacitive loads to electric distribution systems using SSPCs which allow to control the overcurrents in the SSPCs.

In one aspect, these and other objects are achieved by a connection procedure of a very capacitive load to a voltage bus of an electric distribution system through an SSPC, in which the current of the SSPC is actively controlled, keeping one of its parameters constant during the whole connection time t_{c} of said very capacitive load, or during each one of the set of stretches of said time.

In a preferred embodiment said parameter is the magnitude of the current iSSPC, which is maintained constant in a value less than or equal to the maximum value iMAX endured by the SSPC, during the whole connection time t_{c}. This way, a reduction of the maximum current is achieved.

In another preferred embodiment, said parameter is the derivative K of the current iSSPC, which is maintained constant during the whole connection time t_{c}, while the absolute value of the current iSSPC is maintained under or equal to the maximum value i_{MAX} endured by the SSPC. This way, a reduction of the connection time and, particularly, a reduction of the maximum power dissipated during the first moments is achieved.

In another preferred embodiment, during a first stretch tₛ, said parameter is the derivative K of the current iSSPC until it reaches an objective absolute value smaller or equal to the maximum value i_{MAX} endured by the SSPC; and during a second stretch, tₘ, said parameter is the magnitude of the current I_{SSPC}, which is maintained constant at previous said value. Preferably said first stretch tₛ is comprised between 70% and 80% of the connection time t_{c}, and said second stretch tₘ is comprised between 20% and 30% of the connection time t_{c}. This way, a reduction of the connection time and of the maximum power dissipated during the first moments is achieved.

In another preferred embodiment, in each of the first stretches t₁, ..., tₙ₋₁ of the connection time t_{c}, said parameter is a derivative K₁, ..., Kₙ₋₁ of the current i_{SSPC} until it reaches an absolute value smaller or equal to the maximum value i_{MAX} endured by the SSPC and, in the final stretch tₙ, said parameter is the magnitude of the current i_{SSPC} which is maintained constant and equal to said value. Preferably, in each of said stretches, the current i_{SSPC} is inside the safe operation curve of the semiconductor (SOA). This way, an optimization of the trajectory of the current depending on the limitations of the SSPC, the slope of the current and the maximum current through the SSPC is achieved, so that the best use of the semiconductor is achieved and its maximum dissipated power is limited.

In another aspect, the aforementioned objects are achieved by providing an SSPC which can be used in an electrical distribution system between a voltage bus and a very capacitive load, which comprises a semiconductor (preferably a MOSFET or a IGBT), a driver, a microcontroller, an internal power source, an SSPC current measuring device, a measuring device for the load voltage and also current controlling circuits connected to said microcontroller and said driver, which allow to carry out any of said procedures for the connection of very capacitive loads. These control circuits enable the optimization of the SSPC to improve its response times and decrease the power loss by the semiconductor during the connection transients.

In a preferred embodiment, said circuits include suitable components to carry out the active control of the current i_{SSPC} by the SSPC, regulating the voltage V_{GS} or V_{CE} of the control entrance of the semiconductor.

Other characteristics and advantages of the present invention will be clear from the following detailed description of embodiments illustrative of its object in relation to the attached figures.

### BRIEF DESCRIPTION OF THE DRAWINGS

Figure 1 shows the diagram during the connection of a capacitive load to a voltage bus through an SSPC and Figure 2 shows time graphs of the overcurrent and the voltage during the connection transient of a very capacitive load.
Figure 3 shows the variation over time of the current in the SSPC during the connection of the very capacitive load in the active control with constant current procedure according to the present invention.
Figure 4 shows the variation over time of the current in the SSPC during the connection of the very capacitive load in the active control with slope constant current procedure according to the present invention.
Figure 5 shows the variation over time of the current in the SSPC during the connection of the very capacitive load in the generalized active control procedure according to the present invention.
Figure 6 shows the variation over time of the current in the SSPC during the connection of the very capacitive load in the active control by optimum trajectory current procedure according to the present invention.
Figure 7 shows the power dissipated in the semiconductor during the connection transient of a very capacitive load, for the four procedures mentioned.
Figure 8 is a block diagram of an SSPC according to the present invention.
Figure 9 is a block diagram which illustrates the functionality of the control circuits incorporated in the SSPC according to the present invention.
Figures 10 and 11 are detailed diagrams of preferred embodiments of said SSPC control circuits.

### DETAILED DESCRIPTION OF THE PREFERRED EMBODIMENTS

In an aircraft electric distribution system that uses SSPCs as control devices for the connection of the loads, one of the problems which arises is the connection of very capacitive loads, which are present in a great number of the aircraft devices which require electrical energy and which, as is known, can cause overcurrents in the SSPCs, damaging them.

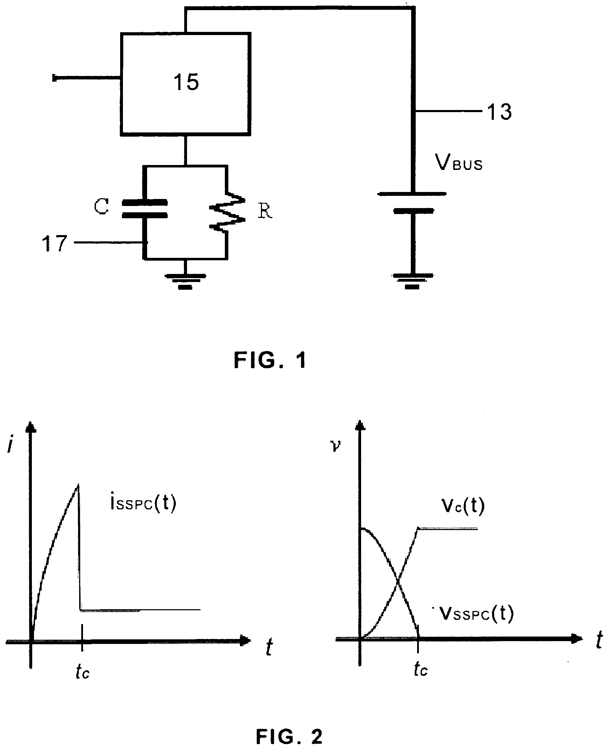

That way, for example, in the system illustrated in Figure 1, during the connection of the very capacitive load 17 using the SSPC 15, overcurrents are produced which are directly related to the value of the capacitor of the load 17 and to the value of the bus voltage V_{BUS} 13 in which is connected. Figure 2 shows the variation over time of the current i_{SSPC}(t) in the SSPC 15 and the voltages vc(t), v_{SSPC}(t) in, respectively, the load 17 and the SSPC 15, during the connection period which ends at time *t_{c}.*

The overcurrent is caused by the initial energy demand of the capacitor, as it is initially uncharged. Therefore, if the current through the SSPC 15 is not controlled during the connection of a very capacitive load 17, an overcurrent is produced which reaches a level high enough to charge the capacitor connected to the output of the SSPC 15, with the voltage V_{BUS} fixed by the main bus 13.

These types of connections present several problems, firstly, they can irreversibly damage the semiconductor and, as a consequence, the SSPC 15 and, secondly, due to the overcurrents, perturbations are introduced which can affect the rest of the neighbouring components or the own power source.

As far as the present invention is concerned, it shall be understood that a very capacitive load 17 is a load with, preferably, a capacity of more than 150 microfarads.

The basic idea of the present invention to cope with this problem, is to provide a procedure for the connection of a very capacitive load 17 to a voltage bus 13 using an SSPC 15, in which an active control is carried out, which maintains a parameter of the current i_{SSPC}(t) of the SSPC 15 constant during the whole connection time t_{c} of said very capacitive load 17, or during each one of a set of stretches of said time.

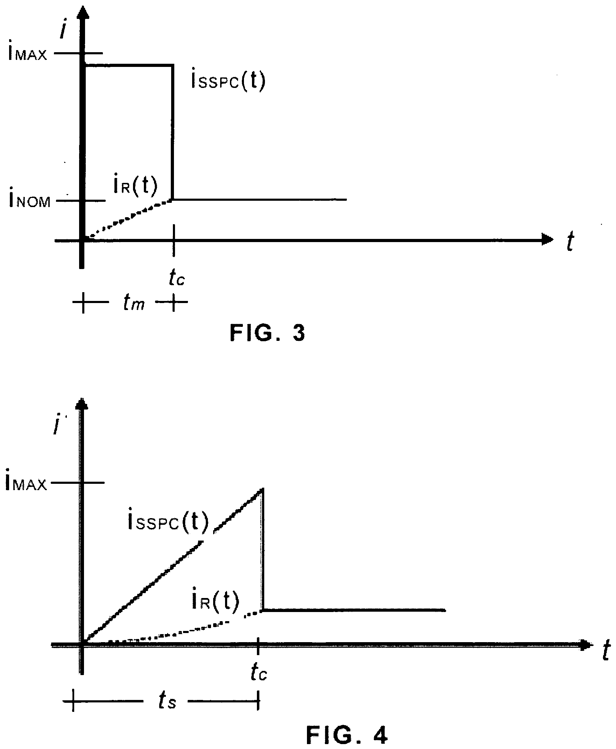

In a first embodiment of the procedure, which we will refer to as active control with constant current procedure, illustrated in Figure 3, an active control is carried out which maintains a constant value for the current iSSPC(t) in the SSPC 15, over the nominal value iNOM, but below the maximum level i_{MAX} endured by the SSPC, during the connection time, which ends at *t_{c}.* Figure 3 also shows the variation over time of the current i_{R}(t) in the load 17 during the connection time. This active control with constant current procedure through the SSPC 15 is better than the passive control procedures known in the prior art and allows the connection of big capacitors in small connection times. The connection times of the loads can also be configured and no hardware modifications of the device are required to implement other connection times. The connection of the load by maintaining a constant current means that the semiconductor must endure high powers during the first moments.

In a second embodiment of the procedure, which we will refer to as active control with slope constant current procedure, illustrated in Figure 4, an active control is carried out to connect the very capacitive load 17 by a current ramp i_{SSPC}(t) in the SSPC 15, whose derivative K is maintained constant during a connection time *t_{c}*, which varies depending on the capacity of the load 17, never exceeding the maximum level endured by the SSPC 15. Figure 4 also shows the variation over time of the current i_{R}(t) in the load during the connection time. This active control with slope constant K current procedure through the SSPC 15 is also better than the passive control procedures and allows the connection of big capacitors in small connection times (but bigger than those achieved by the active control with constant current procedure, although the power dissipated is less). On the other hand, the connection times of the loads can be configured and no hardware modifications of the device are required to implement other connection times.

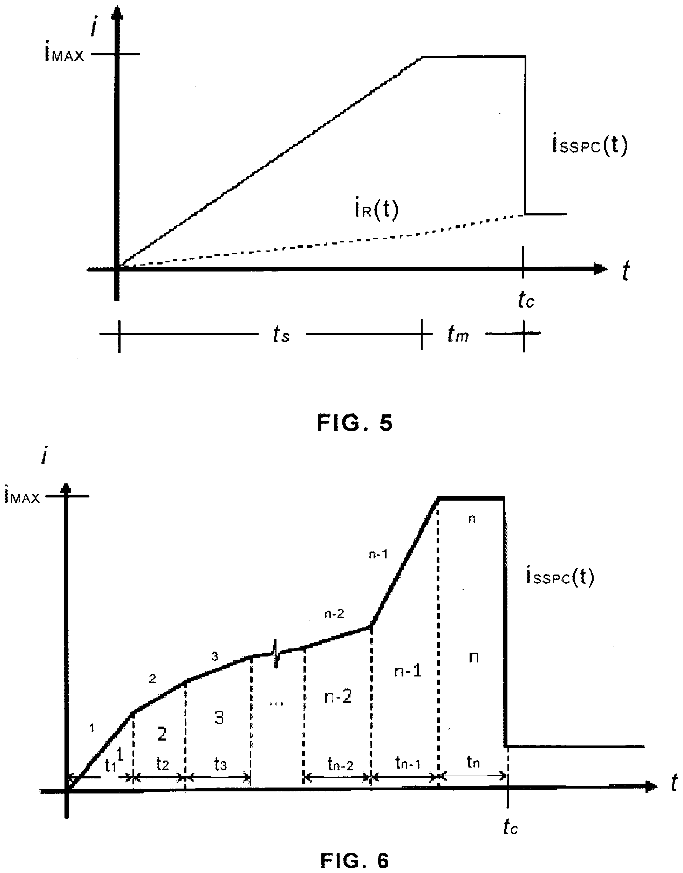

In a third embodiment of the procedure, which we will refer to as for a generalized active control procedure, illustrated in Figure 5, an active control is carried out to connect a very capacitive load 17 in two stretches: the first by means of a current ramp i_{SSPC}(t) whose derivative K is maintained constant during a certain period of time tₛ until it reaches a value that never exceeding the maximum level i_{MAX} endured by the SSPC 15, and the second in which the current is maintained constant during a maintenance period of time tₘ, until the capacitor is completely charged. Figure 5 also shows the variation over time of the current i_{R}(t) in the load during the connection time. Even though the time periods tₛ and tₘ assigned to said stretches are variable time periods determined depending on the characteristics of the load 17, in a preferred embodiment of the invention, a time period tₛ comprised between 70% and 80% of t_{c} and a time period tₘ comprised between 30% and 20% of t_{c} are assigned. This generalized active control procedure is more versatile than the previous ones, as it allows the connection of big capacitors in small connection times, with smaller dissipated powers when compared with the procedure by active control with a constant current, although the power dissipated is greater than in the case of the procedure by active control with constant derivative K of the current. On the other hand, the connection times of the loads can be configured and no hardware modifications of the device are required to implement other connection times, as in the case of the other two procedures mentioned.

In a fourth embodiment, which we will refer to as active control by optimum trajectory current procedure, illustrated in Figure 6, an active control is carried out which allows the connection of a very capacitive load 17 in several stretched of three types:
- Stretch with constant derivative of the current, with an initial value of zero.
- Stretch with constant derivative of the current, with an initial value different to zero.
- Stretch at a constant current.

In any case, the first stretch of connection is a stretch with constant derivative of the current, which is the method which imposes the smallest thermal dissipation in the semiconductor during the first moments, and the final stretch is at a constant current. In the most general case with n stretches, the trajectory of the current in said n stretches with durations t₁, t₂, ... tₙ, is determined by fixing the constant derivatives K₁, ..., Kₙ of each stretch, taking into account the safe operation curve of the semiconductor (SOA). This active control by optimum trajectory current procedure improves the connection of the load, compared to the three preceding procedures, as it allows the connection of big capacitors in small connection times, optimizing the dissipated powers. On the other hand, as in the preceding procedures, the connection times of the loads can be configured and no hardware modifications of the device are required to implement other connection times. The main advantage is it allows a reduction in the number of semiconductor elements needed for the commutation of a very capacitive load because, by means of this procedure, the SSPC adjusts the connection times depending on the load, regardless of its value. It also improves the connection times of the load, compared with the other active control procedures, as it uses 100% of the functioning regions of the semiconductor and adjusts itself to the SOA of the main semiconductor.

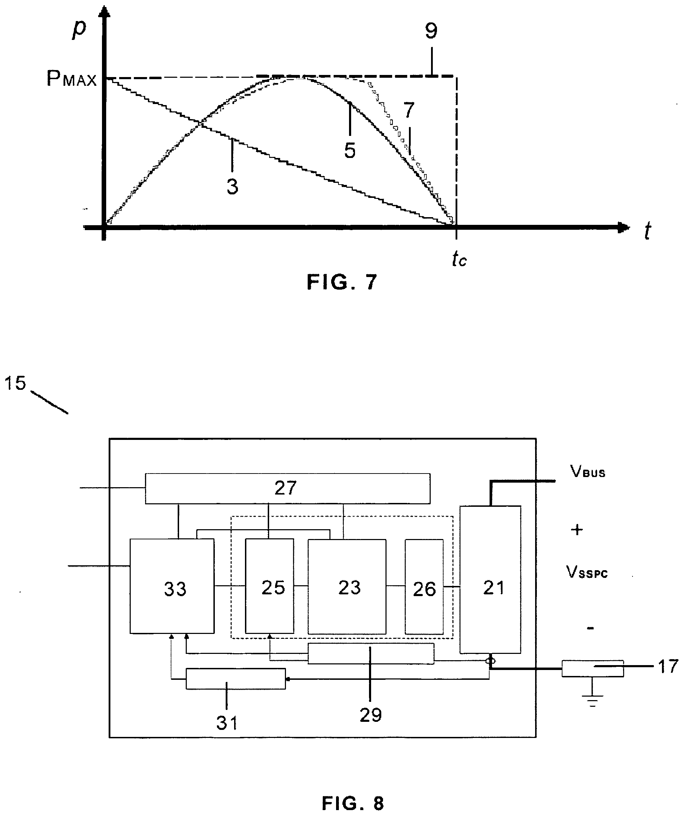

Figure 7 shows the variation over time of the dissipated powers 3, 5, 7, 9 in, respectively, the active control with constant current procedure, the active control with slope constant current procedure, the generalized active control procedure and the active control by optimum trajectory current procedure. Considering the dissipated powers, it can be said that the maximum exploitation of the semiconductor is produced by the active control by optimum trajectory current procedure, while the minimum exploitation of the semiconductor is produced by the active control with constant current procedure.

On the other hand, Table 1 shows, as an example, the results obtained with the four procedures mentioned with regard to the use of the semiconductor. As can be observed, the relation between the average power dissipated by the semiconductor during the connection time, t_{c}, and the maximum power that can dissipate, according to the SOA is different, depending on the connection procedure. The capacity which can be connected during the same connection time, t_{c}, increases, as a better use of the semiconductor is achieved.

**Table 1**

| | **V_{BUS} [V]** | **I_{MAX} [A]** | **I_{NOM} [A]** | **t_{c} [ms]** | **C [µF]** | **P_{AVG} [W]** | **P_{Max} [W]** | **P_{AVG}/P_{Max} [%]** |
|---|---|---|---|---|---|---|---|---|
| Active control with constant current | 270 | 4,4 | 1 | 10 | 143,6 | 568 | 120 0 | 47,33% |
| Active control with slope constant current | 270 | 11,7 | 1 | 10 | 204,3 | 781 | 120 0 | 65,08% |
| Generalized active control (75% tₛ ;25% tₘ) | 270 | 10,95 | 1 | 10 | 239,5 | 794 | 120 0 | 66,17% |
| Active control by optimum trajectory current | 270 | 200 | 1 | 10 | 316,4 | 1200 | 120 0 | 100% |

Figure 8 shows a block diagram of an SSPC 15, in which the preceding active control procedures can be implemented, which includes a semiconductor 21, a driver 23, current control circuits 25, 26, an internal power source 27, a measuring device for the load voltage 31, a measuring device for the SSPC current 29 and a microcontroller 33. The invention is applicable to any semiconductor (bipolar, SIC, etc) and preferably to a MOSFET or an IGBT.

Said current control circuits 25, 26 are made up of components which allow the implementation of the connection procedures mentioned.

A description of a preferred embodiment of said circuits, in relation to the Figures 8, 9, 10, 11 will now follow.

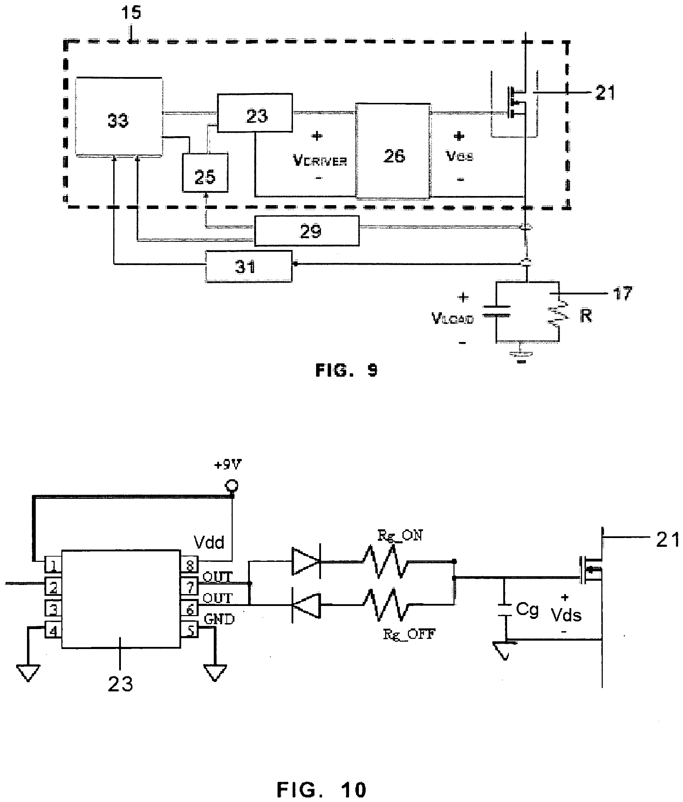

The aim of the driver 23 that controls the semiconductor 21 is to control the voltage between gate and source of the semiconductor used, from the optocoupled output signals, which will be provided by the microcontroller 33. Taking into account that a driver 23 exists, which switches the semiconductor 21 on and off, a control circuit 26 is defined, which enables a control of the output current of the SSPC 15 by regulating the voltage V_{GS} or V_{CE} of the control entrance of the semiconductor 21 (see Figure 9).

Figure 10 shows the regulating circuit 26 of the voltage in the capacitor Cg, which works together with the driver 23, which enables a regulation of the charge and discharge of the gate capacitor Cg, with different time constants. This way, the regulation is optimum and there are no sudden jumps in the Cg voltage and in the semiconductor 21 gate, and as a consequence, great changes in the current levels through the SSPC 15 are avoided. To achieve these times, a circuit made up of diode networks and resistors (RgON y RgOFF), which respectively limit the charge and discharge of the capacitor, is included.

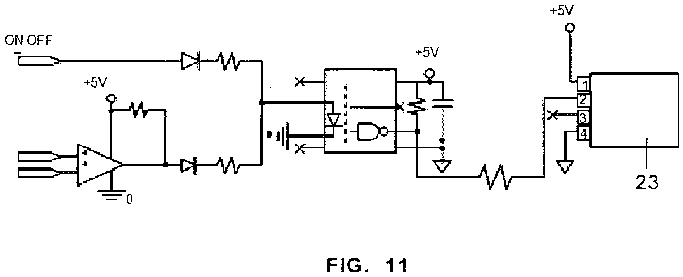

The shoot pulses of the driver 23 are regulated by the microcontroller and are programmable according to the maximum current, connection time or safe operation area of the semiconductor (SOA) requisites. To that purpose, a feedback loop 25 based in an operational amplifier configured as a comparator (see Figure 11) has been added. By means of this amplifier, the current level measured in the SSPC 15 by the current measuring device 29 is compared with the level fixed by the microcontroller, be it a ramp, a constant level, or any other control signal. This comparator generates the shoot pulses needed during the connection transients, so that it regulates the charge and discharge of the capacitor Cg voltage, and then the current through the SSPC 15 during the connection transient of the very capacitive load 17.

Although the present invention has been described in relation to preferred embodiments, it is evident that modifications within its scope can be introduced, understanding that it isn't limited to said embodiments, but to the content of the following claims.

## Claims

1. A procedure for the connection of a capacitive load (17) to a voltage bus (13) of an electric distribution system using a solid state power controller (SSPC) (15), **characterized in that** the current (i_{SSPC}) through the SSPC (15) is controlled actively during the whole connection time (t_{c}) until the capacitive load (17) is charged up to the voltage of the voltage bus (13) by maintaining constant the derivative (K) of the current (i_{SSPC}) during one or a set of stretches of the connection time (t_{c}) until the current (i_{SSPC}) reaches a value equal to the maximum value (i_{MAX}) endured by the SSPC (15) and by maintaining constant that value of the current (_{iSSPC}) in a final stretch.

2. A procedure according to claim 1, wherein the capacity of said capacitive load (17) is greater than 150 microfarads.

3. A procedure according to any of claims 1-2, wherein the voltage of the voltage bus (13) is 270v.

4. A procedure according to any of claims 1-3, wherein the derivative (K) of the current (i_{SSPC}) is maintained constant during a first stretch (tₛ) of the connection time (t_{c}) until the current (i_{SSPC}) reaches a value equal to the maximum value (i_{MAX}) endured by the SSPC (15) and by maintaining constant that value of the current (i_{SSPC}) during a second stretch (tₘ) of the connection time (t_{c}).

5. A procedure according to claim 4, wherein the first stretch (tₛ) is comprised between 70% and 80% of the connection time (t_{c}), and the second stretch (tₘ) is comprised between 30% and 20% of the connection time (t_{c}).

6. A procedure according to any of the claims 1-3, wherein the derivative (K) of the current (i_{SSPC}) is maintained constant during a set of first stretches (t₁, ..., tₙ₋₁) of the connection time (t_{c}), until the current (i_{SSPC}) reaches a value equal to the maximum value (i_{MAX}) endured by the SSPC (15) and by maintaining constant that value of the current (i_{SSPC}) during a final stretch (tₙ) of the connection time (t_{c}).

7. A procedure according to claim 6, wherein during all said stretches (t₁, ..., tₙ) the current (I_{SSPC}) is inside the semiconductor safe operation curve (SOA) of the SSPC (15).

8. An SSPC (15) for connecting a capacitive load (17) to a voltage bus (13) of an electrical distribution system, the SSPC (15) comprising a semiconductor (21), a driver (23), a microcontroller (33), an internal power source (27), a measuring device for the SSPC current (29), and a measuring device for the load voltage (31), **characterized in that** the SSPC also comprises current control circuits (25, 26) connected to said microcontroller (33) and said driver (23) which allow carrying out a connecting procedure of said capacitive load (17) according to any of the claims 1-7.

9. An SSPC (15) according to claim 8, wherein said current control circuits (25, 26) comprise suitable components to carry out the active control of the current (i_{SSPC}) through the SSPC (15) regulating the voltage (v_{GS} or v_{CE}) of the control entrance of the semiconductor (21).

10. An SSPC (15), according to any of the claims 8-9, wherein the semiconductor (21) is a MOSFET.

11. An SSPC (15), according to any of the claims 8-9, wherein the semiconductor (21) is an IGBT.

## Patentansprüche

1. Verfahren zur Verbindung einer kapazitiven Last (17) mit einem Spannungsbus (13) eines elektrischen Verteilungssystems, das einen Solid-State-Leistungssteller (SSPC) (15) verwendet, **dadurch gekennzeichnet, dass** der Strom (i_{SSPC}) durch den SSPC (15) während der gesamten Verbindungszeit (t_{c}) aktiv gesteuert wird, bis die kapazitive Last (17) bis zu der Spannung des Spannungsbusses (13) aufgeladen ist, indem die Ableitung (K) des Stroms (i_{SSPC}) während einer oder einer Reihe von Zeitspannen der Verbindungszeit (t_{c}) konstant gehalten wird, bis der Strom (i_{SSPC}) einen Wert erreicht, der gleich dem Maximalwert (i_{MAX}) ist, dem der SSPC (15) standhalten kann, und indem dieser Wert des Stroms (i_{SSPC}) in einer letzten Zeitspanne konstant gehalten wird.

2. Verfahren nach Anspruch 1, wobei die Kapazität der kapazitiven Last (17) größer als 150 Mikrofarad ist.

3. Verfahren nach einem der Ansprüche 1-2, wobei die Spannung des Spannungsbusses (13) 270v beträgt.

4. Verfahren nach einem der Ansprüche 1-3, wobei die Ableitung (K) des Stroms (i_{SSPC}) während einer ersten Zeitspanne (tₛ) der Verbindungszeit (t_{C}) konstant gehalten wird, bis der Strom (i_{SSPC}) einen Wert erreicht, der gleich dem Maximalwert (i_{MAX}) ist, dem der SSPC (15) standhalten kann, und indem dieser Wert des Stroms (i_{SSPC}) während einer zweiten Zeitspanne (tₘ) der Verbindungzeit (t_{c}) konstant gehalten wird.

5. Verfahren nach Anspruch 4, wobei die erste Zeitspanne (tₛ) zwischen 70% und 80% der Verbindungszeit (t_{c}) beträgt, und die zweite Zeitspanne (tₘ) zwischen 30% und 20% der Verbindungszeit (t_{c}) beträgt.

6. Verfahren nach einem der Ansprüche 1-3, wobei die Ableitung (K) des Stroms (i_{SSPC}) während einer Reihe von ersten Zeitspannen (t₁, ..., tₙ₋₁) der Verbindungszeit (t_{c}) konstant gehalten wird, bis der Strom (i_{SSPC}) einen Wert erreicht, der gleich dem Maximalwert (i_{MAX}) ist, dem der SSPC (15) standhalten kann, und indem dieser Wert des Stroms (i_{SSPC}) während einer letzten Zeitspanne (tₙ) der Verbindungszeit (t_{c}) konstant gehalten wird.

7. Verfahren nach Anspruch 6, wobei während aller Zeitspannen (t_{1,} ... tₙ) der Strom (I_{SSPC}) innerhalb der Kurve des sicheren Arbeitsbereiches (SOA) des Halbleiters des SSPC (15) liegt.

8. SSPC (15) zum Verbinden einer kapazitiven Last (17) mit einem Spannungsbus (13) eines elektrischen Verteilungssystems, wobei der SSPC (15) einen Halbleiter (21), einen Treiber (23), einen Mikrocontroller (33), eine interne Stromquelle (27), eine Messeinrichtung für den SSPC-Strom (29) und eine Messeinrichtung für die Lastspannung (31) umfasst, **dadurch gekennzeichnet, dass** der SSPC auch Stromsteuerschaltungen (25, 26) umfasst, die mit dem Mikrocontroller (33) und dem Treiber (23) verbunden sind, die das Ausführen eines Verbindungsverfahrens der kapazitiven Last (17) nach einem der Ansprüche 1-7 ermöglichen.

9. SSPC (15) nach Anspruch 8, wobei die Stromsteuerschaltungen (25, 26) geeignete Komponenten umfassen, um die aktive Steuerung des Stroms (i_{SSPC}) durch den SSPC (15) auszuführen, wobei die Spannung (v_{GS} oder v_{CE}) des Steuereingangs des Halbleiters (21) geregelt wird.

10. SSPC (15) nach einem der Ansprüche 8-9, wobei der Halbleiter (21) ein MOSFET ist.

11. SSPC (15) nach einem der Ansprüche 8-9, wobei der Halbleiter (21) ein IGBT ist.

## Revendications

1. Procédure de connexion d'une charge capacitive (17) à un bus de tension (13) d'un système de distribution électrique à l'aide d'un contrôleur de puissance à semi-conducteurs (SSPC) (15), **caractérisée en ce que** le courant (i_{SSPC}) qui traverse le SSPC (15) est contrôlé activement pendant l'intégralité de la durée de connexion (t_{c}), jusqu'à ce que la charge capacitive (17) soit chargée à la tension du bus de tension (13) en maintenant constante la dérivée (K) du courant (i_{SSPC}) pendant un ou un ensemble d'intervalle (s) de temps de la durée de connexion (t_{c}), jusqu'à ce que le courant (i_{SSPC}) atteigne une valeur égale à la valeur maximale (i_{MAX}) subie par le SSPC (15), et en maintenant constante cette valeur du courant (i_{SSPC}) pendant un intervalle de temps final.

2. Procédure selon la revendication 1, dans laquelle la capacité de ladite charge capacitive (17) est supérieure à 150 microfarads.

3. Procédure selon l'une quelconque des revendications 1 à 2, dans laquelle la tension du bus de tension (13) est de 270 V.

4. Procédure selon l'une quelconque des revendications 1 à 3, dans laquelle la dérivée (K) du courant (i_{SSPC}) est maintenue constante pendant un premier intervalle de temps (tₛ) de la durée de connexion (t_{c}), jusqu'à ce que le courant (i_{SSPC}) atteigne une valeur égale à la valeur maximale (i_{MAX}) subie par le SSPC (15), et en maintenant constante cette valeur du courant (i_{SSPC}) pendant un second intervalle de temps (tₘ) de la durée de connexion (t_{c}).

5. Procédure selon la revendication 4, dans laquelle le premier intervalle de temps (tₛ) est compris entre 70% et 80% de la durée de connexion (t_{c}), et le second intervalle de temps (tₘ) est compris entre 30% et 20% de la durée de connexion (t_{c}).

6. Procédure selon l'une quelconque des revendications 1 à 3, dans laquelle la dérivée (K) du courant (i_{SSPC}) est maintenue constante pendant un ensemble de premiers intervalles de temps (t₁, ..., tₙ₋₁) de la durée de connexion (t_{c}), jusqu'à ce que le courant (i_{SSPC}) atteigne une valeur égale à la valeur maximale (i_{MAX}) subie par le SSPC (15), et en maintenant constante cette valeur du courant (i_{SSPC}) pendant un intervalle de temps final (tₙ) de la durée de connexion (t_{c}).

7. Procédure selon la revendication 6, dans laquelle, pendant l'ensemble desdits intervalles de temps (t₁, ..., tₙ), le courant (i_{SSPC}) se trouve dans les limites de la courbe de fonctionnement sécurisé des semi-conducteurs (SOA) du SSPC (15).

8. SSPC (15) destiné à connecter une charge capacitive (17) à un bus de tension (13) d'un système de distribution électrique, le SSPC (15) comprenant un semi-conducteur (21), un excitateur (23), un microcontrôleur (33), une source d'énergie interne (27), un dispositif de mesure destiné au courant du SSPC (29), et un dispositif de mesure destiné à la tension de charge (31), **caractérisé en ce que** le SSPC comprend en outre des circuits de contrôle de courant (25, 26) reliés audit microcontrôleur (33) et audit excitateur (23) qui permettent d'exécuter une procédure de connexion de ladite charge capacitive (17) selon l'une quelconque des revendications 1 à 7.

9. SSPC (15) selon la revendication 8, dans lequel lesdits circuits de contrôle du courant (25, 26) comprennent des composants adaptés pour exécuter le contrôle actif du courant (i_{SSPC}) qui traverse le SSPC (15) en régulant la tension (V_{GS} ou V_{CE}) de l'entrée de contrôle du semi-conducteur (21).

10. SSPC (15) selon l'une quelconque des revendications 8 à 9, dans lequel le semi-conducteur (21) est un MOSFET.

11. SSPC (15) selon l'une quelconque des revendications 8 à 9, dans lequel le semi-conducteur (21) est un IGBT.
